# EUROPÄISCHE PATENTSCHRIFT

(11) **EP 0 704 894 B1**
(45) Veröffentlichungstag und Bekanntmachung des Hinweises auf die Patenterteilung: **04.12.2002**
(21) Anmeldenummer: 95114958.2
(22) Anmeldetag: 22.09.1995
(51) Int. Cl.: H01L 21/768, H01L 21/28

(54) **Verfahren zur Erzeugung eines niederohmigen Kontaktes zwischen einer Metallisierungsschicht und einem Halbleitermaterial**
Process for forming a low ohmic contact between a metallic layer and a semiconductor material
Procédé pour former un contact de faible valeur ohmique entre une couche de métallisation et un substrat semi-conducteur

(30) Priorität: 23.09.1994 DE 4434108
(43) Veröffentlichungstag der Anmeldung: 03.04.1996
(73) Patentinhaber: Infineon Technologies AG, 81669 München (DE)
(72) Erfinder: Werner, Wolfgang, Dr., D-81545 München (DE); Wiesinger, Klaus, Dr., D-81479 München (DE); Preussger, Andreas, Dr., D-85591 Vaterstetten (DE)
(74) Vertreter: Bickel, Michael

(56) Entgegenhaltungen:
- US-A- 4 853 345
- US-A- 5 171 705
- PATENT ABSTRACTS OF JAPAN vol. 012, no. 449 (E-686), 25.November 1988 & JP 63 177565 A (NEC CORP), 21.Juli 1988,

## Beschreibung

Die Erfindung betrifft ein Verfahren zur Erzeugung eines niederohmigen Kontaktes zwischen einer Metallisierungsschicht und einem Halbleitermaterial eines ersten Leitfähigkeittyps, über dessen Halbleiteroberfläche eine Isolationsschicht und eine Halbleiterschicht angeordnet ist.

Ein derartiger Kontakt ist beispielsweise aus der US-PS 4,898,835 bekannt. Die Isolationsschicht und die Halbleiterschicht sind durch das Gateoxid und das Gate eines MOS-Leistungstransistors gegeben. Die bekannte Struktur eignet sich vorwiegend für Einzelbauelemente, nicht jedoch für integrierte Schaltungen mit Leistungselementen.

Weiterhin ist in der US-PS 5,171,705 eine Halbleiterstruktur beschrieben, bei der ein solcher Kontakt zwischen einer Metallisierungsschicht und einer Vorderseite eines Halbleiterkörpers gebildet ist.

Der Erfindung liegt die Aufgabe zugrunde, ein Verfahren der eingangs genannten Art anzugeben, das zu einer kleinen Kontaktfläche und einem niedrigen Kontaktwiderstand führt.

Diese Aufgabe wird durch die Merkmale des Patentanspruchs 1 erreicht.

Die Erfindung hat den Vorteil, dass sich eine kleinere Kontaktöffnung ergibt, ohne dass eine Mehrzahl von Justiervorhalten berücksichtigt werden muß. Durch die kleinere Fläche des Kontaktbereichs ergibt sich ein geringerer Einschaltwiderstand, so dass die abzuführende Verlust- bzw. Schaltleistung einen geringeren Kühlungsaufwand ermöglicht. Darüber hinaus ermöglicht diese Erfindung die Reduzierung parasitärer Effekte, so dass auch in kritischen Fällen eine Steuerung der Schalteigenschaften über die strukturierte Halbleiterschicht bzw. Gate möglich ist. Aufgrund des reduzierten Widerstandes zwischen dem Kontaktbereich und dem Kanalgebiet ergibt sich ein stabileres Durchbruchsverhalten der Anordnung. Alle an dem Verfahren beteiligten Diffusionen sind selbstjustiert auf die strukturierte Halbleiterschicht.

Ausgestaltungen des Erfindungsgedankens sind in den Unteransprüchen gekennzeichnet.

Die Erfindung wird nachfolgend anhand von Figuren der Zeichnung näher dargestellt. Es zeigen:
FIG 1 bis 5 schematische Darstellungen des erfindungsgemäßen Verfahrens,
FIG 6 eine schematische Darstellung eines integrierten Kontaktbereiches eines DMOS-Transistors gemäß FIG 1 bis FIG 5 und
FIG 7 bis 10 schematische Darstellungen weiterer Ausführungsbeispiele des erfindungsgemäßen Verfahrens für unterschiedliche Transistortypen.

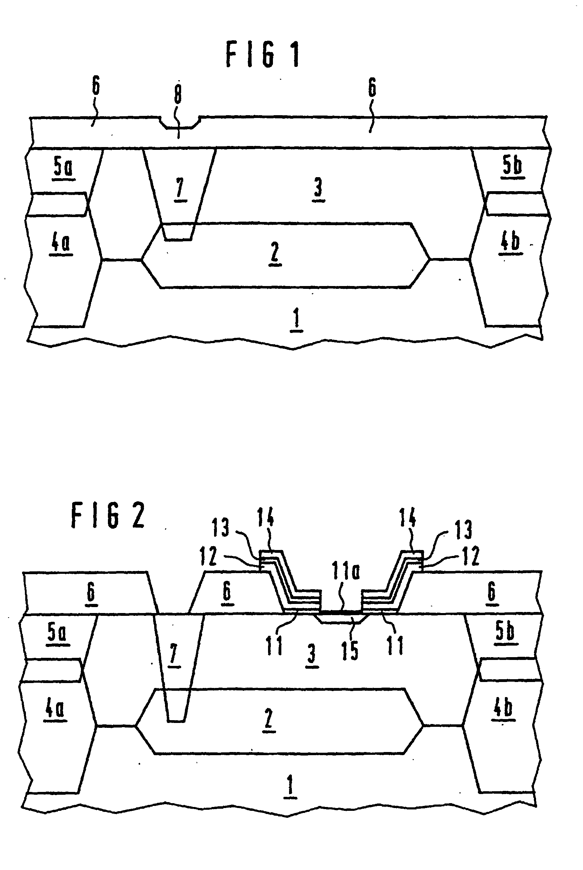

Die Erfindung geht von einer Struktur gemäß FIG 1 aus. Über einem Halbleitermaterial 1 mit Bor-Dotierung und beliebiger Orientierung ist eine n-dotierte Wanne 3 z. B. epitaktisch angeordnet. Die Wanne 3 wird durch eine Zone 2 hoher Leitfähigkeit niederohmig kontaktiert. Isoliert wird die Wanne durch p-dotierte Bereiche 4a, 4b sowie 5a und 5b mit jeweils hoher Leitfähigkeit. Der niederohmige Wannenanschluß 2 ist mit der Oberfläche der Wanne 3 durch ein Tiefdiffusionsgebiet 7 hoher Leitfähigkeit verbunden. Das Tiefdiffusionsgebiet 7 wird erzeugt, indem eine die Oberfläche der Anordnung abdekkende Isolationsschicht 6, beispielsweise aus Siliziumoxid zunächst strukturiert wird, danach beispielsweise mittels Ofenbelegung eine n-dotierte Schicht hoher Leitfähigkeit'in der Wanne erzeugt wird, die anschließend eingetrieben wird. Dabei entsteht auf der strukturierten Oberfläche ein termisch erzeugtes Oxid 8.

In entsprechender Weise kann in einem anderen Bereich der Halbleiteranordnung eine p-Wanne erzeugt werden.

Ausgehend von FIG 1 werden die aktiven Bauelementebereiche erzeugt. Dazu wird gemäß FIG 2 zunächst die Oxidschicht 6 mittels einer Standard-Fototechnik und naßchemischer Ätzung strukturiert, wobei der Oxidwinkel mit einer Vorimplantation niedriger Dosis eingestellt werden kann. Diese Vorimplantation kann beispielsweise eine ganzflächige Argonimplantation sein. Daran schließen sich weitere an sich bekannte Schritte an. Bei CMOS-Transistoren kann die Einsatzspannung der Transistoren durch eine entsprechende Dotierung niedriger Dosis eingestellt werden.

Mit dem nächsten Schritt erfolgt die Erzeugung einer Isolationsschicht 11, beispielsweise als thermisch erzeugtes Siliziumoxid. Bei MOS-Transistoren erfüllt diese Schicht die Funktion einer Gateisolation. Danach wird eine Halbleiterschicht 12 aufgebracht, beispielsweise eine Polysiliziumsschicht. Die Schicht 12 wird auf hohe Leitfähigkeit mittels Ofenbelegung dotiert. Aus dieser Schicht werden das Gate eines MOS-Transistors, ein Widerstand oder eine Leitbahn erzeugt.

Im nächsten Schritt wird auf die Halbleiterschicht eine erste Isolierschicht mit einem vorgegebenen Gehalt an Dotierstoffen aufgebracht. Diese erste Isolierschicht dient als Getterschicht. Der Gehalt an Dotierstoffen wird so gewählt, daß eine Getterwirkung auftritt, wobei diese erste Isolierschicht geringe Verfließeigenschaften haben sollte. Beispielsweise kann die erste Isolierschicht eine Borphosphorsilikatglasschicht (BPSG) sein. Möglich ist auch ein Sandwich aus zwei Schichten 13 und 14, von denen bevorzugt die untere Schicht Phosphor- oder Bor-dotiert ist, während die obere Schicht 14 undotiert sein kann. Im Extremfall kann die erste Isolierschicht auch undotiert sein, wenn eine später aufzubringende zweite Isolierschicht dotiert ist. Die bevorzugt verwendete Doppelschicht aus einem dotierten Oxid 13 und einem undotierten Oxid 14, typischerweise TEOS, wird anschließend mittels einer Standardfototechnik strukturiert und anisotrop geätzt.

Unter Verwendung der ersten Isolierschicht 13, 14 als Maske wird nachfolgend die Halbleiterschicht 12 anisotrop geätzt. Möglich ist ein anschließend erfolgendes Dünnen der freiliegenden Isolationsschicht 11 auf Streuoxiddicke 11a mittels einer anisotropen oder isotropen Ätzung.

Im nächsten Schritt erfolgt die Implantation eines p-dotierten Dotierstoffes 15 mittlerer Leitfähigkeit in das Halbleitermaterial. Die entstandene Anordnung zeigt FIG 2.

Nach dem Eintreiben der p-dotierten Schicht 15 erfüllt diese Zone im Ausführungsbeispiel die Funktion des Body eines DMOS-Transistors. Bei anderen Anordnungen kann diese Zone die Funktion der Basis eines npn-Transistors, die Source oder das Drain eines PMOS-Transistors, den Emitter eines pnp-Transistors oder einen Diffusionswiderstand als Funktion erfüllen. Die für die Implantation vorgesehene Fototechnik ist eine Standard-Lack-Fototechnik.

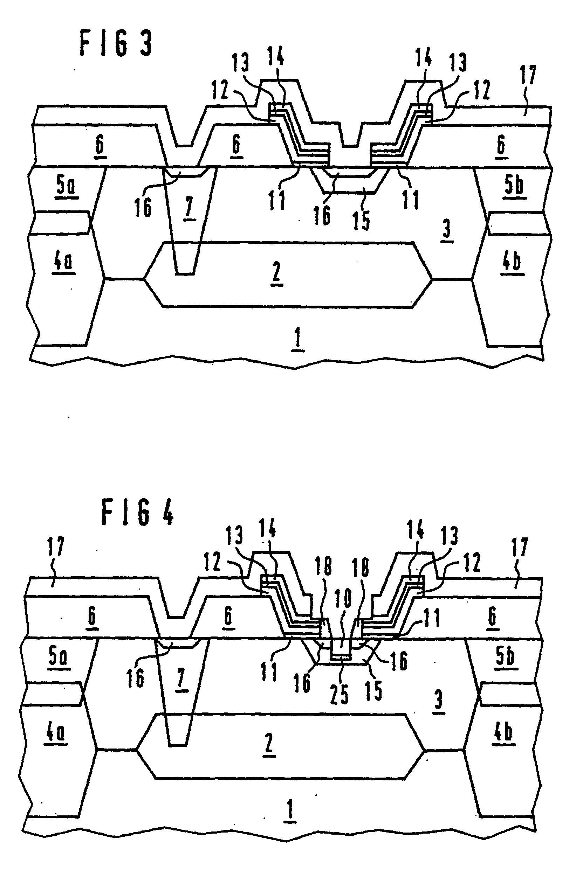

Mittels einer weiteren Standard-Lack-Fototechnik werden in dem Halbleitermaterial n-dotierte Zonen 16 hoher Leitfähigkeit implantiert und eingetrieben. Als Funktion kann die Source eines DMOS-Transistors, können aber auch der Emitter eines npn-Transistors oder Source und Drain eines MMOS-Transistors vorgesehen sein. Im Anschluß an das Eintreiben der n-dotierten Schichten 16 erfolgt das Aufbringen einer zweiten Isolationsschicht 17, FIG 3. Die zweite Isolierschicht ist vorzugsweise ein Phosphor- oder Bor-haltiges Oxid und hat eine ähnliche Dicke wie die erste Isolierschicht bzw. wie die Summe der Sandwichschichten 13 und 14. Die zweite Isolierschicht kann beispielsweise wiederum eine Borphosphorsilikatglasschicht sein. Anschließend kann die Schicht 17 in einem Ofenprozeß verdichtet werden, wobei die Schicht nicht stark verfließen sollte.

Im nächsten Verfahrensschritt ist eine Strukturierung der zweiten Isolierschicht mit Hilfe einer weiteren Fototechnik und einer anisotropen Ätzung bis zur Halbleiteroberfläche vorgesehen. Das bedeutet, daß der Ätzschritt auf der Halbleiteroberfläche stoppt. Unter Verwendung der so erzeugten Struktur der Schicht 17 im Bereich des zu erzeugenden Kontaktes als Maske wird anschließend das Halbleitermaterial geätzt, FIG 4. Der entstehende Graben 10 hat aufgrund des durch die Schicht 17 gebildeten Spacers 18 einen festen Abstand zur strukturierten Halbleiterschicht 12, d. h. zur Polysiliziumkante.

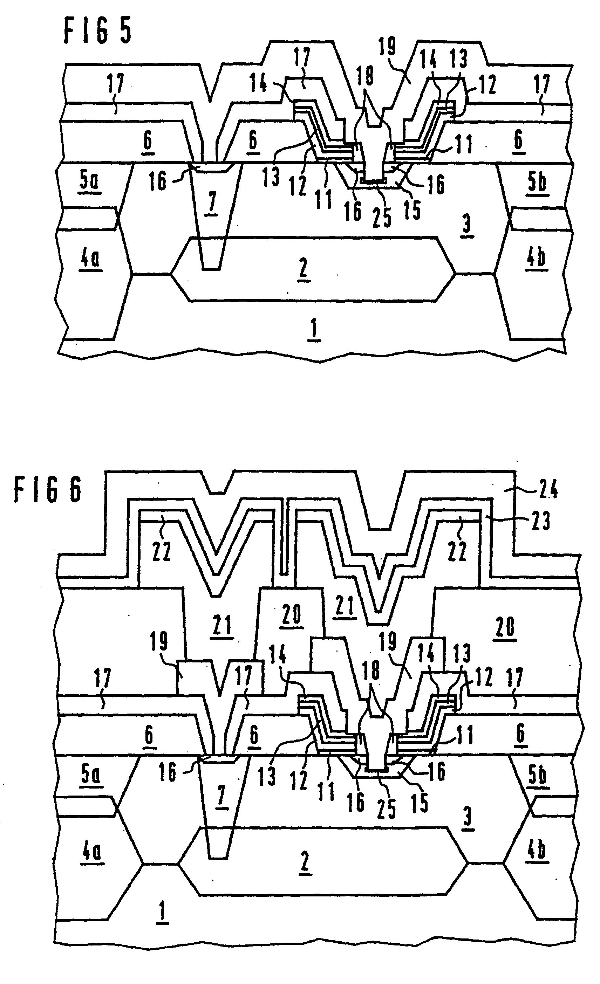

Danach wird als dritter Isolierstoff eine p-Dotierung 25 hoher:Dosis in das Halbleitermaterial, d.h. in den Boden des erzeugten Siliziumgrabens implantiert. Die Funktion dieses Schrittes ist die Reduzierung der Kontaktwiderstände bzw. bei einer anderen Anordnung der Emitter eines pnp-Transistors. Die Maskierung bei diesem Schritt erfolgt wiederum durch die zweite Isolierschicht 17. Im nächsten Schritt gemäß FIG 5 wird ganzflächig eine Metallisierungsschicht 19, beispielsweise aus Aluminium aufgebracht. Die Funktion dieser Schicht ist die Kontaktierung des Halbleitermaterials bzw. die Funktion einer Leitbahn.

Die nachfolgenden Schritte zur Herstellung der Halbleiterstrukturen entsprechen den aus dem Stand der Technik bekannten Schritten. Beispielsweise kann das Oxid 17 vor dem Aufbringen der Metallisierungsschicht 19 mittels einer Standardfototechnik und naßchemischer oder anisotroper Ätzung zur Erzeugung von Kontakten ohne Siliziumgraben 10 strukturiert werden, FIG 5. Nach dem Aufbringen der Metallisierungsschicht wird diese strukturiert, eine Isolationsschicht 20, typisch TEOS, abgeschieden und strukturiert und eine Planarisierung der Oberfläche der sich ergebenden Anordnung durchgeführt. Es folgt ein Aufbringen und Strukturieren einer zweiten leitfähigen Schicht 21 unter Bildung von Kontakten zwischen erster und zweiter leitfähiger Schicht. Danach wird eine weitere Isolationsschicht 22 abgeschieden und strukturiert. Eine weitere Isolationsschicht 23, typisch ein phosphorhaltiges Oxid wird aufgebracht, über der als Passivierungsschicht eine Siliziumnitridschicht 24 vorgesehen ist, FIG 6.

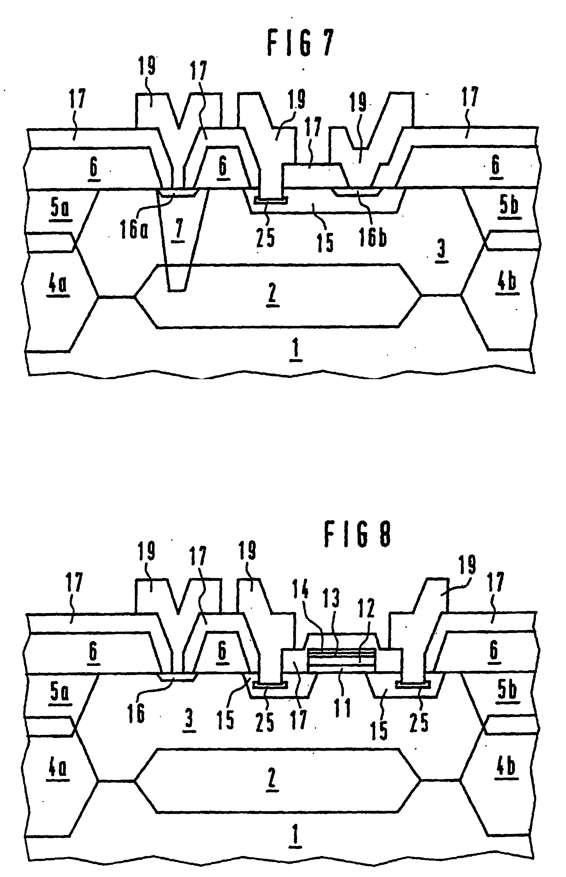

Das gemäß der Figuren 1 bis 6 erläuterte Verfahren eignet sich zur Herstellung von integrierten Schaltkreisen mit verschiedenen Typen von Bauelementen. Während die Figuren 1 bis 6 die Herstellung eines n-Kanal-DMOS-Transistors mit Drain- oder Source-Kontakt auf der Oberseite der Halbleiterscheibe darstellt, zeigen die Figuren 7 bis 10 unter Beibehaltung der entsprechenden Bezugszeichen andere Typen von Bauelementen.

Der npn-Transistor gemäß FIG 7 zeigt als Zone 16a den Kollektorkontakt, der über die Kollektortiefdiffusion zur vergrabenen Zone 2 den Kollektor 3 kontaktiert. Zone 15 stellt die Basis da, 16b den Emitter.

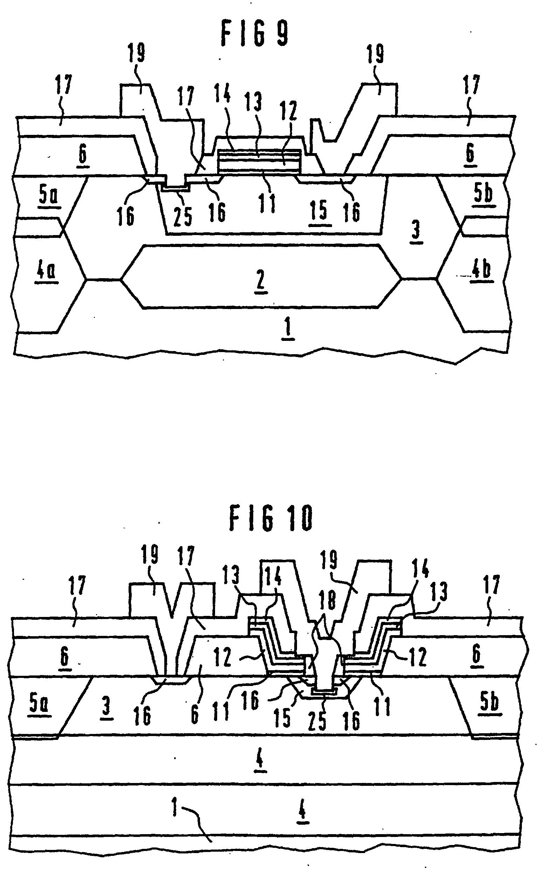

Figuren 8 und 9 zeigen Niedervolt-CMOS-Transistoren, wobei die Zonen 15 beim PMOS-Transistor in FIG 8 bzw. 16 beim NMOS-Transistor in FIG 9 die Source- bzw. Drainzonen sind. In FIG 9 ist die Zone 15 als p-Wanne für den NMOS-Transtor vorgesehen.

Mit Hilfe des erfindungsgemäßen Verfahrens sind weiterhin hochsprerrende p-Kanal-Transistoren, Widerstände, Kapazitäten und Dioden realisierbar. Alle Bauelemente sind voneinander durch pn-Übergänge isoliert.

Für die Herstellung von integrierten Schaltkreisen mit DMOS-Transistoren deren Drain-Kontakt auf der Scheibenrückseite liegt, können einzelne, dem Fachmann geläufige Schritte vor der Herstellung der aktiven Bauelementebereiche weggelassen werden. Als Grundmaterial wird n-leitendes Silizium hoher Leitfähigkeit bestimmter Orientierung verwendet. Am Ende des gesamten Herstellungsprozesses ist vorgesehen, eine leitfähige Schicht auf der Scheibenrückseite aufzubringen. Ein sich ergebender hochsperrender isolierter, lateraler n-Kanal-DMOS-Transistor zeigt FIG 10.

Das erfindungsgemäße Verfahren eignet sich auch für die Herstellung von DMOS-Einzeltransistoren, wobei in dem anhand der Figuren 1 bis 6 beschriebenen Herstellungsprozeß einzelne Schritte abgewandelt bzw. weggelassen werden können, ohne daß der unter Schutz gestellte erfindungsgemäße Kerngedanke geändert wird. Als Grundmaterial wird auch in diesem Fall n-leitendes Silizium hoher Leitfähigkeit vorgegebener Orientierung verwendet, und am Prozeßende muß eine leitfähige Schicht auf der Scheibenrückseite aufgebracht werden.

## Patentansprüche

1. Verfahren zur Erzeugung eines niederohmigen Kontaktes zwischen einer Metallisierungsschicht (19) und einem Halbleitermaterial (3) eines ersten Leitfähigkeitstyps, auf dessen Halbleiter-Oberfläche eine Isolationsschicht (11) und darüber eine Halbleiterschicht (12) angeordnet sind,
mit dem folgenden Schritten :
- auf der Halbleiterschicht (12) wird eine erste Isolierschicht (13, 14) aufgebracht und mittels anisotroper Ätzung unter Bildung einer ersten und einer zweiten Öffnung strukturiert,
- unter Verwendung der ersten Isolierschicht (13, 14) als Maske wird die Halbleiterschicht (12) anisotrop geätzt,
- ein erster Dotierstoff (15) eines zweiten Leitfähigkeitstyps (p) wird mit Hilfe einer ersten Fototechnik durch die erste Öffnung in das Halbleitermaterial implantiert und eingetrieben, wobei eine erste Zone (15) in dem Halbleitermaterial (3) gebildet wird,
- ein zweiter Dotierstoff (16) vom ersten Leitfähigkeitstyps (n) wird mit Hilfe einer zweiten Fototechnik durch die zweite Öffnung in das Halbleitermaterial (3) implantiert,
- ganzflächig wird eine zweite dotierte Isolierschicht (17) aufgebracht,
- die zweite Isolierschicht wird anisotrop bis auf die Halbleiteroberfläche zurückgeätzt, wobei in der ersten Öffnung randseitige Isolationsstege (18) verbleiben,
- das Halbleitermaterial (3) wird selbstjustiert unter Verwendung der zweiten Isolierschicht (17, 18) als Maske anisotrop bis in die erste Zone (15) geätzt,
- ein dritter Dotierstoff (25) höherer Dotierung als der erste Dotierstoff (15) und vom zweiten Leitfähigkeitstyp wird unter Verwendung der zweiten Isolierschicht als Maske in die erste Zone (15) implantiert und
- eine Metallisierungsschicht (19) wird aufgebracht.

2. Verfahren nach Anspruch 1,
**dadurch gekennzeichnet,**
**daß** zusätzlich eine weitere Isolierschicht (14) auf die erste Isolierschicht (13) aufgebracht wird und daß beide Schichten etwa gleich strukturiert werden.

3. Verfahren nach Anspruch 1 oder 2,
**dadurch gekennzeichnet,**
**daß** die Isolationsschicht (11) vor der Implantation des ersten Dotierstoffs (15) gedünnt wird.

4. Verfahren nach einem der Ansprüche 1 bis 3,
**dadurch gekennzeichnet,**
**daß** durch den ersten Dotierstoff (15) eine mittlere Leitfähigkeit sowie durch den zweiten und den dritten Dotierstoff jeweils eine hohe Leitfähigkeit des implantierten Gebiets erzeugt wird.

5. Verfahren nach einem der Ansprüche 1 bis 4,
**dadurch gekennzeichnet,**
**daß** die zweite dotierte Isolierschicht (17) im wesentlichen die gleiche Dicke wie die erste dotierte Isolierschicht (13, 14) hat.

6. Verfahren nach einem der Ansprüche 1 bis 5,
**dadurch gekennzeichnet,**
**daß** die zweite dotierte Isolierschicht (17) unter Bildung von seitlich an die Isolationsschicht (11), die Halbleiterschicht (12) und die erste Isolierschicht (13, 14) angrenzenden Isolationsstege (18) strukturiert wird.

7. Verfahren nach einem der Ansprüche 1 bis 6,
**dadurch gekennzeichnet,**
**daß** die zweite dotierte Isolierschicht (17) vor ihrer Strukturierung verdichtet wird.

8. Verfahren nach einem der Ansprüche 1 bis 7,
**dadurch gekennzeichnet, daß** die erste und die zweite Öffnung identisch sind.

## Claims

1. A process for producing a low-impedance contact between a metallisation layer (19) and a semiconductor material (3) of a first conductivity type, on the semiconductor surface of which an insulating layer (11) and over it a semiconductor layer (12) are disposed,
having the following steps:
- a first insulating layer (13, 14) is applied on the semiconductor layer (12) and is structured by means of anisotropic etching by forming a first and a second aperture,
- by using the first insulating layer (13, 14) as a mask, the semiconductor layer (12) is anisotropically etched,
- a first dopant (15) of a second conductivity type (p) is implanted and driven into the semiconductor material through the first aperture by using a first photographic technique, with a first zone (15) being formed in the semiconductor material (3),
- a second dopant (16) of the first conductivity type (n) is implanted through the second aperture into the semiconductor material (3) by using a second photographic technique,
- a second doped insulating layer (17) is applied over the complete area,
- the second insulating layer is anisotropically etched back to the semiconductor surface, with insulation tabs at the edge remaining in the first aperture,
- the semiconductor material (3) is anisotropically etched right into the first zone (15) in self-aligned manner by using the second insulating layer (17, 18) as a mask,
- a third dopant (25) having a higher doing than the first dopant (15) and of the second conductivity type is implanted into the first zone (15) by using the second insulating layer as a mask and
- a metallisation layer (19) is applied.

2. A process according to Claim 1,
**characterised in that** in addition another insulating layer (14) is applied to the first insulating layer (13)
and **in that** both layers have roughly the same structure.

3. A process according to Claim 1 or 2,
**characterised in that** the insulating layer (11) is thinned prior to the implantation of the first dopant (15).

4. A process according to one of Claims 1 to 3,
**characterised in that** an average conductivity is produced by the first dopant (15) and also a high conductivity of the implanted area is produced by the second and the third dopants.

5. A process according to one of Claims 1 to 4,
**characterised in that** the second doped insulating layer (17) has substantially the same thickness as the first doped insulating layer (13, 14).

6. A process according to one of Claims 1 to 5,
**characterised in that** the second doped insulating layer (17) is structured with the formation of insulating tabs (18) laterally adjacent to the insulating layer (11), the semiconductor layer (12) and the first insulating layer (13, 14).

7. A process according to one of Claims 1 to 6,
**characterised in that** the second doped insulating layer (17) is compressed before its structuring.

8. A process according to one of Claims 1 to 7,
**characterised in that** the first and the second openings are identical.

## Revendications

1. Procédé de fabrication d'un contact faiblement ohmique entre une couche de métallisation (19) et une matière semi-conductrice (3) d'un premier type de conductivité dont la surface semi-conductrice porte une couche d'isolation (11) et par-dessus celle-ci une couche semi-conductrice (12), comprenant les étapes suivantes :
- sur la couche semi-conductrice (12), on applique une première couche d'isolation (13, 14) et par gravure anisotrope, on forme et on structure une première et une seconde ouvertures,
- en utilisant la première couche d'isolation (13, 14) comme masque, on effectue une gravure anisotrope de la couche semi-conductrice (12),
- on implante et on enfonce une première matière dopante (15) d'un second type de conductivité (p) à l'aide d'une première technique de photorésist à travers la première ouverture de la matière semi-conductrice, en formant une première zone (15) dans la matière semi-conductrice (3),
- on implante une seconde matière dopante (16) du premier type de conductivité (n) à l'aide d'une seconde opération de photorésist à travers la seconde ouverture dans la matière semi-conductrice (3),
- on applique une seconde couche d'isolation, dopée (17) sur toute la surface,
- on enlève par gravure la seconde couche d'isolation, de manière anisotrope jusqu'à la surface de la matière semi-conductrice et dans la première ouverture, on laisse subsister des nervures d'isolation 18 marginales,
- on grave la matière semi-conductrice (3) de matière auto-réglée en utilisant la seconde couche d'isolation (17, 18) comme masque anisotrope jusqu'à la première zone (15),
- on implante une troisième matière dopante (25) avec un dopage plus élevé que celui de la première matière dopante (15) et du second type de conductivité en utilisant la seconde couche isolante comme masque dans la première zone (15) et,
- on applique une couche de métallisation (19).

2. Procédé selon la revendication 1,
**caractérisé en ce qu'**
en plus on applique une autre couche d'isolation (14) sur la première couche d'isolation (13) et on structure sensiblement de la même manière les deux couches.

3. Procédé selon la revendication 1 ou 2,
**caractérisé en ce qu'**
on amincit la couche d'isolation (11) avant l'implantation de la première matière dopante (15).

4. Procédé selon l'une quelconque des revendications 1 à 3,
**caractérisé en ce que**
par la première matière isolante (15), on développe une conductivité moyenne et par la seconde et la troisième matières isolantes, on développe chaque fois une conductivité élevée de la zone d'implantation.

5. Procédé selon l'une quelconque des revendications 1 à 4,
**caractérisé en ce que**
la seconde couche d'isolation dopée (17) a essentiellement la même épaisseur que la première couche d'isolation dopée (13, 14).

6. Procédé selon l'une quelconque des revendications 1 à 5,
**caractérisé en ce qu'**
on structure la seconde couche d'isolation dopée (17) en formant des nervures d'isolation (18) à côté sur la couche d'isolation (11), la couche semi-conductrice (12) et la première couche d'isolation (13, 14).

7. Procédé selon l'une quelconque des revendications 1 à 6,
**caractérisé en ce que**
l'on compacte la seconde couche d'isolation dopée (17) avant de la mettre en structure.

8. Procédé selon l'une quelconque des revendications 1 à 7,
**caractérisé en ce que** la première et la seconde ouvertures sont identiques.
